(19) Europäisches Patentamt

**European Patent Office**

**Office européen des brevets**

(11) Veröffentlichungsnummer: **0 308 654 B1**

(12) **EUROPÄISCHE PATENTSCHRIFT**

(45) Veröffentlichungstag der Patentschrift: **01.04.92**

(51) Int. Cl.⁵: **G01R 33/28**, G01N 24/08

(21) Anmeldenummer: **88113492.8**

(22) Anmeldetag: **19.08.88**

(54) **Vorrichtung zum Zuführen eines Probenträgers bei einem NMR-Spektrometer.**

(30) Priorität: **05.09.87 DE 3729819**

(43) Veröffentlichungstag der Anmeldung:
**29.03.89 Patentblatt 89/13**

(45) Bekanntmachung des Hinweises auf die
Patenterteilung:
**01.04.92 Patentblatt 92/14**

(84) Benannte Vertragsstaaten:
**CH DE FR GB LI**

(56) Entgegenhaltungen:
**EP-A- 0 197 791**
**CH-A- 635 434**
**GB-A- 1 576 929**
**US-A- 4 581 583**

(73) Patentinhaber: **Spectrospin AG**
**Industriestrasse 26**
**CH-8117 Zürich-Fällanden(CH)**

(72) Erfinder: **Kuster, Anton**
**Müllerwis 25**
**CH-8606 Greifensee(CH)**

(74) Vertreter: **KOHLER SCHMID + PARTNER Patentanwälte**
**Ruppmannstrasse 27**
**W-7000 Stuttgart 80(DE)**

**Beschreibung**

Die Erfindung betrifft eine Vorrichtung zum Zuführen eines Probenträgers bei einem NMR-Spektrometer, das einen Hochfeld-Kryomagneten mit vertikal angeordneter Achse aufweist, der in einem vorgegebenen Meßbereich ein homogenes statisches Magnetfeld erzeugt, mit einem diesen Meßbereich durchsetzenden, vertikalen Führungsrohr, mit einer am oberen Ende des Führungsrohres angeordneten Wechseleinrichtung zum Übergeben und Entnehmen eines Probenträgers an das bzw. aus dem Führungsrohr und mit einer Einrichtung zum Zuführen von unter Druck stehendem Gas zum unteren Ende des Führungsrohres, mit der das dem Führungsrohr zugeführte Gas so dosierbar ist, daß ein an das Führungsrohr übergebener Probenträger wahlweise zum Durchführen einer Messung von dem oberen Ende des Führungsrohres bis in den Meßbereich des Kryomagneten abgesenkt und danach zum Entnehmen des Probenträgers wieder bis zum oberen Ende des Führungsrohres angehoben werden kann.

Eine derartige Vorrichtung ist beispielsweise aus der US 45 81 583 und der EP 01 97 791 A2 bekannt. Die eine dieser Vorrichtungen weist als Wechseleinrichtung ein Magazin mit einem rotierenden Probenhalter auf, dessen Probenträger enthaltende Aufnahmen über dem Ende des Führungsrohres positioniert werden können, während die andere Vorrichtung einen Roboterarm aufweist, mit dem Probenträger einem Magazin entnommen und an das Führungsrohr übergeben werden können und umgekehrt. Diese Vorrichtungen sind kompliziert und dann nicht wirtschaftlich anwendbar, wenn Proben nicht reihenweise, sondern einzeln untersucht werden sollen.

Wenn keine automatische Zufuhr der Probenträger stattfindet, hat die auch als "pneumatischer Lift" bezeichnete Vorrichtung zum Einbringen oder Entfernen der Probe in den bzw. aus dem Meßbereich des Kryomagneten eines NMR-Spektrometers den Nachteil, daß bei großen Magnetanordnungen das obere Ende des Führungsrohres für den Benutzer des Spektrometers nicht mehr vom Boden des Raumes aus erreichbar ist, in dem die Magnetanordnung aufgestellt ist. Er ist daher gezwungen, sich beim Auswechseln einer Probe einer Leiter zu bedienen, oder es müßte neben der Magnetanordnung ein Podest aufgestellt werden. Es ist die Benutzung einer Leiter nicht nur umständlich und das Anordnen eines Podestes nicht nur kostspielig, sondern es muß der zum Aufstellen einer Leiter oder Errichten eines Podestes notwendige Platz neben der Magnetanordnung vergesehen werden. Hieraus können sich erhebliche Beschränkungen bei der Wahl des Aufstellungsortes für die Magnetanordnung ergeben. Außerdem sollte jede zeitliche Änderung in der Umgebung des Magneten vermieden werden, die irgendwelche Rückwirkungen auf das sehr hohe Magnetfeld und die empfindliche Meßapparatur des NMR-Spectrometers haben könnte, wie auch der Mensch das hohe Magnetfeld, von dem gewisse Gefahren ausgehen, möglichst meiden sollte. In dieser Hinsicht bereitet auch bei den oben behandelten Vorrichtungen einerseits das Laden des am oberen Ende des Kryomagneten angeordneten Probenhalters und andererseits in der unmittelbaren Umgebung des Kryomagneten arbeitenden Roboters Probleme.

Demgemäß liegt der Erfindung die Aufgabe zugrunde, eine Vorrichtung der eingangs genannten Art so auszubilden, daß es dem Benutzer des NMR-Spektrometers möglich ist, den Probenwechsel von einer gut zugänglichen Stelle aus vorzunehmen, und daß sie keinen nennenswerten zusätzlichen Platzbedarf hat.

Diese Aufgabe wird nach der Erfindung dadurch gelöst, daß die Wechseleinrichtung ein Schrägrohr, das von einer dem oberen Ende des Führungsrohres benachbarten Stelle zu einer außerhalb der Magnetanordnung liegenden, gut zugänglichen Stelle führt und dort mit einer verschließbaren Öffnung zum Einsetzen und Entnehmen des Probenträgers versehen ist, und einen Richtungsschalter umfaßt, der ein wahlweise auf das Führungsrohr und auf das Schrägrohr ausrichtbares Rohrstück aufweist, und daß die Einrichtung zum Zuführen des unter Druck stehenden Gases auch mit dem verschlossenen unteren Ende des Schrägrohres verbunden und derart steuerbar ist, daß der im Führungsrohr bei auf das Führungsrohr ausgerichtetem Rohrstück des Richtungsschalters bis in den Bereich des Richtungsschalters angehobene Probenträger nach Verstellen des Richtungsschalters im Schrägrohr zum Zwecke der Entnahme absenkbar ist und umgekehrt.

Bei der erfindungsgemäßen Magnetanordnung wird demgemäß dafür Sorge getragen, daß die mittels des Führungsrohres bis über die Struktur des Magneten angehobene Probe mittels des Schrägrohres an der Außenseite der Magnetstruktur abgesenkt und damit an eine Stelle gebracht werden kann, die für den Benutzer des Spektrometers ohne weiteres erreichbar ist. Diese Stelle kann sich in unmittelbarer Nähe der Spektrometer-Konsole, also in unmittelbarer Nähe des normalen Arbeitsplatzes des Benutzers eines solchen Spektrometers befinden. Dabei hat die nach der Erfindung vorgesehene Ausbildung des Probentransportsystems weder einen nennenswerten Platzbedarf noch erfordert sie kostspielige und komplizierte Einrichtungen. Dies gilt insbesondere dann, wenn als Gas zum Transportieren der Probe Luft verwendet wird. Ein anderes geeignetes Gas ist beispielsweise Stickstoff, das als Druckgas Flaschen entnommen werden kann. Wenn im folgenden von "Preßluft" die Rede ist, steht dieser Begriff für ein beliebiges geeignetes, unter Druck stehendes gasförmiges Medium.

Das Einsetzen und Entnehmen des Probenträgers am unteren Ende des Schrägrohres kann dadurch erleichtert werden, daß am unteren Ende des Schrägrohres ein vom Schrägrohr trennbares, einseitig geschlossenes Endstück mit einem Aufnahmeraum für den Probenträger angeordnet ist. Diese Endstück ist selbstverständlich so ausgebildet, daß der Probenträger zum Einsetzen und Entnehmen gut zugänglich ist und der Probenträger in dem Endstück sicher gehalten ist. Die Befestigung des Endstückes am Schrägrohr kann beispielsweise mittels eines Bajonettverschlusses, aber auch mittels federnder Rastglieder od. dgl. erfolgen.

Zur Steuerung der Bewegung des Probenträgers bedarf es wie bisher nur dreier Betriebszustände für die Einrichtung zum Zuführen von Preßluft, nämlich einen das Anheben, einen das Absenken und einen das Schweben der Probe bewirkenden Betriebszustand, wenn in weiterer Ausgestaltung der Erfindung der Richtungsschalter einen beweglichen Abschnitt aufweist, der, wenn das Rohrstück des Richtungsschalters auf des Führungsrohr oder das Schrägrohr ausgerichtet ist, das jeweils andere Rohr dicht abschließt, und wenn außerdem das Führungsrohr mit dem geschlossenen Ende des Endstückes durch eine flexible Leitung verbunden ist, die an das Führungsrohr in einem Abstand von dessen oberem Ende angeschlossen ist, der wenigstens so groß ist wie die Länge des Probenträgers. Je nach der Schaltstellung erfolgt dann das Anheben und Absenken des Probenträgers in dem Führungsrohr oder dem Schrägrohr, wobei gleichzeitig gewährleistet ist, daß ein Übergang des Probenträgers von dem jeweiligen Rohr auf den Richtungsschalter und umgekehrt nur dann stattfinden kann, wenn der Richtungsschalter auf das jeweilige Rohr korrekt ausgerichtet ist.

Der Richtungsschalter kann in einfacher Weise mittels eines Hebelgetriebes manuell verstellbar sein, das zusammen mit dem Richtungsschalter ein System bildet, dessen gemeinsamer Schwerpunkt in den Betriebsstellungen, in denen der Richtungsschalter auf das Führungsrohr oder das Schrägrohr ausgerichtet ist, tiefer liegt als in den dazwischen liegenden Stellungen.

Das für die manuelle Verstellung erforderliche Hebelgetriebe kann außerordentlich einfach und in unmittelbarer Nähe des Führungsrohres angeordnet sein, so daß es auch keinen nennenswerten, zusätzlichen Platz beansprucht. Die Ausbildung des aus Hebelgetriebe und Richtungsschalter bestehenden Systems in solcher Weise, daß der Schwerpunkt des Gesamtsystems im Bereich zwischen den Betriebsstellungen einen höchsten Punkt einnimmt, hat ohne weitere Maßnahmen zum Ergebnis, daß der Richtungsschalter stets bestrebt ist, eine seiner beiden Betriebsstellungen einzunehmen, und in jeder Betriebsstellung eine sichere Ruhelage hat.

Das Probentransportsystem läßt sich natürlich für den Benutzer auch noch komfortabler gestalten, wenn der dazu erforderliche Aufwand als vertretbar angesehen wird. Gerade dann, wenn das Schrägrohr im Bereich der Konsole des Spektrometers enden soll, kann das am Schrägrohr angeordnete Endstück das Rohrstück eines weiteren schwenkbaren Richtungsschalters sein, von dem ein im wesentlichen senkrecht angeordnetes, oben offenes Aufnahmerohr für den Probenträger ausgeht. Dieses oben offene Aufnahmerohr könnte beispielsweise in der Tischplatte einer Konsole enden, so daß dann die Möglichkeit besteht, den Probenträger einfach von oben in dieses Aufnahmerohr einzuführen. Die Einrichtung könnte dann auch so beschaffen sein, daß eine aus dem Magneten ausgestoßene Probe aus dem oberen Ende des Einlagerohres herausragt, so daß sie zum Entnehmen gut ergriffen werden kann. Dabei könnte der weitere Richtungsschalter mit dem am oberen Ende des Führungsrohres angeordneten Richtungsschalter mechanisch gekoppelt sein, um zu gewährleisten, daß die Rohrstücke beider Richtungsschalter stets auf das Schrägrohr ausgerichtet sind, wenn der Probenträger von dem einen Richtungsschalter zum anderen transportiert werden soll. Es bestünde aber auch die Möglichkeit, die Richtungsschalter und die Einrichtung zum Zuführen von Preßluft in Abhängigkeit von im Bereich der Richtungsschalter angeordneten Sensoren mittels eines Steuergerätes automatisch zu verstellen bzw. zu steuern, so daß es genügt, von der Konsole einfach einen das Einfahren oder Ausfahren einer Probe bewirkenden Schalter zu betätigen, um alle dazu erforderlichen Vorgänge zu veranlassen.

Die Erfindung wird im folgenden anhand der in der Zeichnung dargestellten Ausführungsbeispiele näher beschrieben und erläutert. Die der Beschreibung und der Zeichnung zu entnehmenden Merkmale können bei anderen Ausführungsformen der Erfindung einzeln für sich oder zu mehreren in beliebiger Kombination Anwendung finden.

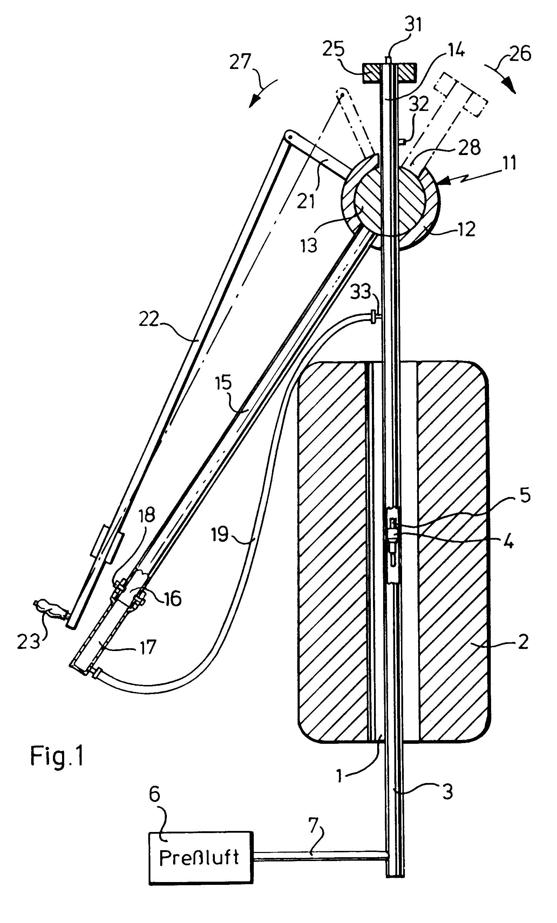

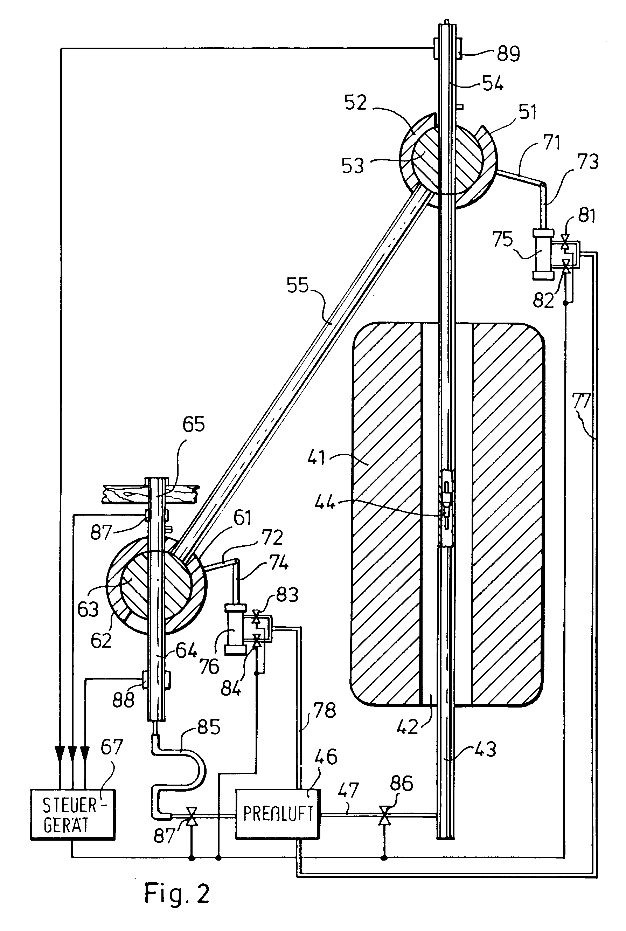

Die Fig. 1 und 2 zeigen jeweils in schematischer Darstellung eine Magnetanordnung mit einem nach der Erfindung ausgebildeten Probentransportsystem.

Bei der in Fig. 1 dargestellten Anordnung wird der zentrale Raum 1 eines schematisch dargestellten Kryomagneten 2 von einem Führungsrohr 3 durchsetzt, in dem sich ein Probenträger 4 befindet. Der Kryomagnet 2 ist Teil eines NMR-Spektrometers, mit dem eine mittels des Probenträgers 4 in den homogenen Bereich des vom Kryomagneten 2 erzeugten Magnetfeldes transportierte Probe 5 untersucht werden kann. In diesen homogenen Bereich des Magnetfeldes, der sich etwa in der Mitte, häufig aber auch unterhalb der Mitte des Kryomagneten 2 befindet, wird der Probenträger 4 mittels Preßluft gebracht, die dem Führungsrohr 3 von einer Einrichtung 6, die mittels eines Rohres 7 an das untere Ende des Führungsrohres 3 angeschlossen ist, zugeführt wird und die auch dazu dient, den Probenträger 4 mit der Probe 5 aus dem Meßbereich des Kryomagneten 2 wieder zu entfernen. Zu diesem Zweck kann die Menge der zugeführten Preßluft so erhöht werden, daß der Probenträger 4 in dem Führungsrohr 3 an dessen oberes Ende getragen wird. Dort befindet sich ein Richtungsschalter 11, der aus einem zylindrischen Gehäuse 12 und einem darin drehbar gelagerten Drehschieber 13 besteht, in den ein Rohrstück 14 eingesetzt ist, das in der aus Fig. 1 ersichtlichen Stellung des Drehschiebers 13 mit dem Führungsrohr 3 fluchtet.

Bei der Einrichtung 6 zum Zuführen von Preßluft kann es sich um ein Gebläse, einen Kompressor, einen Preßluftspeicher o. dgl. handeln und es versteht sich auch, daß der hier der Einfachheit halber gebrauchte Ausdruck "Preßluft" jedes beliebige Druckgas bezeichnen kann. Tatsächlich wird vielfach Stickstoff benutzt und es wird dann die Einrichtung 6 einfach von einer Stickstoff-Flasche gebildet.

In das Gehäuse 12 des Richtungsschalter 11 ist in der gleichen, zur Achse des Drehschiebers 13 senkrechten Ebene wie das Führungsrohr 3 ein Schrägrohr 15 eingesetzt, das von dem Richtungsschalter 11 ausgehend außen an dem Kryomagneten 2 vorbeiführt und dessen Ende 16 sich an einer Stelle befindet, die für den Benutzer des Spektrometers gut zugänglich ist. Auf das Ende 16 des Schrägrohres ist ein Endstück 17 aufgesetzt und beispielsweise mittels eines Bajonett-Verschlusses am unteren Ende des Schrägrohres gehalten, von welchem Bajonett-Verschluß in Fig. 1 die in entsprechende, am Endstück 17 vorgesehene Schlitze eingreifenden Zapfen 18 dargestellt sind. Das untere, im übrigen geschlossene Ende des Endstückes 17 ist über eine flexible Leitung 19 mit dem oberen Ende des Führungsrohres 3 verbunden. Das Rohrstück 14 des Richtungsschalter 11 läßt sich durch Verschwenken des Drehschiebers 13 auf das Schrägrohr 15 ausrichten.

Zum Verschwenken des Drehschiebers 13 dient ein einfaches Hebelgetriebe, das aus einem am Drehschieber befestigten Kurbelarm 21 und einer Schubstange 22 besteht, die am Ende des Kurbelarmes 21 gelenkig befestigt ist und bis zum unteren Ende des Schrägrohres 15 reicht, wo sie mit einem Handgriff 23 versehen ist. Die Schubstange 22 ist nahe ihrem unteren Ende in einer Führung 24 angeornet. Es ist ohne weiteres ersichtlich, daß der Drehschieber 13 aus der dargestellten Stellung durch Bewegen der Schubstange 22 am Handgriff 23 nach oben in die strichpunktiert angedeutete Stellung gebracht werden kann, in der das Rohrstück 14 mit dem Schrägrohr 15 fluchtet. Ein am Ende des Rohrstückes 14 angebrachtes Gewicht 25 übt in der zuletzt genannten Stellung auf den Drehschieber 13 ein Drehmoment in Richtung des Pfeiles 26 aus, das größer ist als das entgegengesetzte Drehmoment in Richtung des Pfeiles 27, das von dem aus dem Kurbelarm 21 und der Schubstange 22 gebildeten Hebelgetriebe auf den Drehschieber 13 ausgeübt wird. Daher hat der Richtungsschalter 11 in der strichpunktiert gezeichneten Lage, in der das Rohrstück 14 mit dem Schrägrohr 15 fluchtet, eine stabile Lage. Eine solche stabile Lage liegt ebenfalls vor, wenn der Drehschieber 13 die in Fig. 1 ausgezogen wiedergegebene Stellung einnimmt, in der das Rohrstück 14 mit dem Führungsrohr 3 fluchtet, weil dann das von dem sich senkrecht über der Achse des Drehschiebers 13 befindenden Gewicht 25 ausgeübte Drehmoment praktisch null ist, so daß das von dem Kurbelarm 21 und der Schubstange 22 ausgeübte Drehmoment in Richtung des Pfeiles 27 stark überwiegt. Demgemäß hat der Richtungsschalter 11 zwei stabile Stellungen, in denen das Rohrstück 14 mit dem Führungsrohr 3 oder dem Schrägrohr 15 fluchtet und welche Stellungen durch das Anschlagen des Rohrstückes 14 an den Enden einer Aussparung 28 definiert sind, die sich in dem Gehäuse 12 des Richtungsschalter befindet.

Da das auf den Drehschieber 13 ausgeübte Drehmoment von der Lage des Massenschwerpunktes des von dem Drehschieber 13, dem Rohrstück 14 mit dem Gewicht 25 und dem aus Kurbelarm 21 und Schubstange 22 bestehenden Hebelgetriebe gebildeten Systems in bezug auf die Schwenkachse des Drehschiebers 13 bestimmt wird, so muß dieser Schwerpunkt in dem einen Fall zu der einen und im andern Fall zu der anderen Seite einer durch die Schwenkachse des Drehschieber 13 verlaufenden vertikalen Ebene liegen. Da die Bewegung des Schwerpunktes nur auf einem Kreisbogen erfolgen kann, dessen Mittelpunkt auf der Schwenkachse des Drehschiebers 13 liegt und dessen höchster Punkt sich senkrecht über dieser Schwenkachse befindet, liegt der gemeinsame Schwerpunkt des Systems in den Betriebsstellungen, in denen der Richtungsschalter mit dem Rohrstück 14 auf das Führungsrohr 3 oder das Schrägrohr 15 ausgerichtet ist, auch tiefer als in den dazwischenliegenden Stellungen.

Es ist ohne weiteres ersichtlich, daß bei der in Fig. 1 wiedergegebenen Stellung des Drehschiebers 13 durch Verstärken der Preßluftzufuhr der Probenträger 4 in dem Führungsrohr angehoben werden kann, bis der Probenträger das obere Ende des mit dem Führungsrohr 3 fluchtenden Rohrstücks 14 erreicht. Eine Öffnung 31 am Ende des Rohrstücks 14 erlaubt ein gedrosseltes Entweichen der von derm Probenträger 4 aus dem Führungsrohr 3 beim Anheben ausgetriebenen Luft, während eine sich im Abstand vom Ende des Rohrstückes 4 befindende Öffnung 32 ein Entweichen der Preßluft ermöglicht, nachdem der Probenträger 4 diese Öffnung passiert hat, so daß der Probenträger in der oberen Endstellung keinem übermäßig großen Druck ausgesetzt ist, jedoch andererseits auch in der oberen Stellung sicher gehalten wird. Dabei bleibt die dem Schrägrohr 15 über die Leitung 19 am unteren Ende des Endstückes 17 zugeführte Preßluft ohne Wirkung, weil in der gezeigten Stellung das obere Ende des Schrägrohres 15 von dem Drehschieber 13 des Richtungsschalter 11 abgesperrt wird. Wird nun durch Betätigen der Schubstange 22 der Drehschieber 13 des Richtungsschalter 11 verschwenkt, so gelangt das sich im Drehschieber 13 befindende Ende des Rohrstückes 14 in den Bereich der Mündung des Schrägrohres 15,

bevor die Verbindung mit dem Führungsrohr 3 völlig getrennt ist. In einer Übergangsphase wird demnach der Probenträger 4 in dem Rohrstück 14 von Preßluft gehalten, die teilweise noch über das Führungsrohr 3 und teilweise schon über das Schrägrohr 15 zugeführt wird. Hat der Drehschieber 13 die strichpunktierte Stellung erreicht, in der das Rohrstück 14 mit dem Schrägrohr 15 fluchtet, so ist der Probenträger 4 der Preßluft ausgesetzt, die zwar dem Führungsrohr 3 zugeführt wird, aber über die Leitung 19 und das Enstück 17 in das Schrägrohr 15 und von dort in das Rohrstück 14 gelangt, weil das Führungsrohr 3 nun an seinem oberen Ende durch den Drehschieber 13 verschlossen ist. Jetzt kann durch Vermindern der Preßluftzufuhr in der gleichen Weise, wie der Probenträger 4 in den Meßbereich abgesenkt wird, der Probenträger bis in das Endstück 17 am unteren Ende des Schrägrohres 15 abgesenkt werden. Nach Lösen des Endstückes 17 kann dann der Probenträger 4 mit der Probe 5 dem zu diesem Zweck im Endstück 17 angeordneten Aufnahmeraum entnommen und gegen einen Probenträger mit einer anderen Probe ausgetauscht werden. Nach Ansetzen des Endstückes 17 kann dann durch Verstärken der Preßluft-Zufuhr der Probenträger wieder in das Rohrstück 14 des Richtungsschalter 11 angehoben und nach Verschwenken des Richtungsschalter 11 durch Herabziehen der Schubstange 22 wieder in gewohnter Weise in den Meßbereich des Kryomagneten 2 abgesenkt werden.

Trotz der sehr einfachen Ausbildung bietet die beschriebene Anordnung ein hohes Maß an Betriebssicherheit. So kann ein sich im Endstück 17 befindlicher Probenträger nur dann zum Richtungsschalter 11 bewegt werden, wenn das Rohrstück 14 auf das Schrägrohr 15 ausgerichtet ist, weil sonst, wie aus Fig. 1 ohne weiteres ersichtlich, die dem Führungsrohr zugeführte Preßluft über die Öffnungen 31, 32 in dem mit dem Führungsrohr 13 fluchtenden Rohrstück 14 entweicht und andererseits das von dem Drehschieber 13 an seinem oberen Ende abgesperrte Schrägrohr 15 keine Luft aufnehmen kann. Ist dagegen der Richtungsschalter 11 auf das Schrägrohr 15 eingestellt, während sich der Probenträger im Führungsrohr 3 befindet, so kann zwar der Probenträger 14 beim Erhöhen der Preßluftzufuhr angehoben werden, solange er sich unterhalb des Anschlusses 33 für die flexible Leitung 19 befindet, weil die von dem Probeträger 4 verdrängte Luft über die Leitung 19 und das am oberen Ende offene Schrägrohr 15 entweichen kann, jedoch entweicht auf diesem Weg auch die dem Führungsrohr 3 zugeführte Preßluft, sobald der Probenträger 4 den genannten Anschluß passiert hat, und bleibt dann im wesentlichen ohne Wirkung, weil sich oberhalb dieses Anschlusses in dem vom Drehschieber 13 abgesperrten Abschnitt des Führungsrohres ein Polster verdichteter Luft befindet, der den Probenträger vom Drehschieber 13 der Richtungsschalter 11 entfernt hält.

Die in Fig, 2 dargestellte Erfindung umfaßt wiederum einen Kryomagneten 41, dessen zentraler Raum 42 von einem Führungsrohr 43 durchsetzt wird, das dazu dient, einen Probenträger 44 mit seiner Probe in den homogenen Meßbereich des vom Kryomagneten 41 erzeugten Magnetfeldes zu bringen. Dabei wird der Probenträger 44 wiederum in dem Führungsrohr 43 durch Preßluft bewegt, die dem Führungsrohr 43 am unteren Ende von einer hierzu ausgebildeten Einrichtung 46 über ein Rohr 47 zugeführt wird.

In diesem Fall ist nicht nur am oberen Ende des Führungsrohres 43 ein Richtungsschalter 51 angeordnet, der in der bereits beschriebenen Weise aus einem Gehäuse 52 und einem im Gehäuse schwenkbar gelagerten Drehschieber 53 besteht, mit dem ein im Drehschieber befestigtes Rohrstück 54 wahlweise mit dem Führungsrohr 43 oder einem im Gehäuse 52 des Richtungsschalter 51 mündenden Schrägrohr 55 zum Fluchten gebracht werden kann, sondern es ist am unteren Ende des Schrägrohres 55 ein weiterer Richtungsschalter 61 angeordnet, der wiederum aus einem zylindrischen Gehäuse 62 und einem in diesem Gehäuse schwenkbar gelagerten Drehschieber mit einem Rohrstück 64 besteht, das wahlweise auf das Schrägrohr 55 oder ein im Gehäuse 62 des Richtungsschalters 61 mündendes Aufnahmerohr 65 ausrichtbar ist. Dieses Aufnahmerohr 65 ist im wesentlichen vertikal angeordnet und kann beispielsweise die Tischplatte 66 der Konsole oder des Steuerpultes des Spektrometers durchdringen, zu dem der Kryomagnet 41 gehört. Es ist ohne weiteres ersichtlich, daß diese Anordnung die Möglichkeit bietet, einen von oben in das Aufnahmerohr 65 eingesetzten Probenträger bis in das Rohrstück 64 des unteren Richtungsschalters 61 abzusenken, nach entsprechendem Einstellen der Richtungsschalter 61, 51 über das Schrägrohr 55 bis in das Rohrstück 54 des oberen Richtungsschalters zu schicken und dann, nach Verschwenken des oberen Richtungsschalters 51, in dem Führungsrohr 43 bis in den homogenen Bereich des vom Kryomagneten 41 erzeugten Magnetfeldes abzusenken, so daß dann die gewünschten Messungen durchgeführt werden können.

Es bedarf keiner Erläuterung, daß die Verstellung der Richtungsschalter und der Preßluftzufuhr ebenso wie bei dem anhand Fig. 1 erläuterten Ausführungsbeispiel manuell erfolgen kann, wobei auch die Möglichkeit besteht, die am oberen und unteren Ende des Schrägrohres 55 angeordneten Richtungsschalter mechanisch miteinander zu koppeln. Ebenso ist aber auch ohne weiteres ersichtlich, daß der Gesamtvorgang des Probenwechsels, beginnend mit dem Einsetzen eines Probenträgers in das Aufnahmerohr 65 bis zum Placieren des Probenträgers im Meßbereich des Kryomagneten 41 sowie nach Durchführen der Messung das Austragen des Probenträgers aus dem Meßbereich und Ablegen im Aufnahmerohr 65 in Abhängigkeit von den von einem Steuergerät gelieferten Steuerbefehlen erfolgen kann. Die in Fig. 2 dargestellte Anordnung ist für einen solchen automatischen Probenwechsel eingerichtet. Zu diesem Zweck sind die Drehschieber 53 und 63 der beiden Richtungsschalter 51 bzw. 61 mit je einem Kurbelarm 71 bzw. 72 versehen, mit dessen Ende die Kolbenstange 73 bzw. 74 eines pneumatischen Zylinders 75 bzw. 76 schwenkbar verbunden ist. Den pneumatischen Zylindern 75, 76 wird Preßluft von der Einrichtung 46 über eine Leitung 77 bzw. 78 zugeführt. Steuerventile 81, 82 bzw. 83, 84 bestimmen, ob die Zufuhr der Preßluft an der Vorder- oder Rückseite des Kolbens des pneumatischen Zylinders 75 bzw. 76 erfolgt und daher in welcher Richtung der Richtungsumschalter verstellt wird. Bei diesem Ausführungsbeispiel der Erfindung findet auch eine von der Preßluftzufuhr zu dem Führungsrohr 43 getrennte Preßluftzufuhr zu dem Rohrstück 64 des am unteren Ende des Schrägrohres 55 angeordneten Richtungsschalters 61 statt. Die Verbindung zwischen der die Preßluft liefernden Einheit 46 und dem Rohrstück 64 erfolgt über eine flexible Leitung 85. Auch die Zufuhr der Preßluft zu dem Führungsrohr 43 und zu dem Rohrstück 64 wird durch ein in der entsprechenden Leitung angeordnetes Steuerventil 86 bzw. 87 bestimmt. Das Steuergerät 67 bewirkt aufgrund eines externen Steuerbefehls, mit dem ein Probentransport eingeleitet wird, die zum Einführen des Probenträgers 44 von dem Aufnahmerohr 65 in die Meßposition oder auch beim Austragen des Probenträgers von der Meßposition in das Aufnahmerohr 65 erforderlichen Schritte der Dosierung der Preßluft und der Umstellung der Richtungsschalter, ähnlich wie es oben anhand Fig. 1 erläutert worden ist, auch wenn hier noch ein weiterer Schritt beim Durchgang durch den Richtungsschalter 61 erforderlich ist. Dabei können die Vorgänge des Probentransportes durch Sensoren 87, 88, 89 überwacht werden, die auf das Vorhandensein des Probenträgers 44 im Aufnahmerohr 65, in dem Rohrstück 64 des unteren Richtungsschalters 61 und in dem Rohrstück 54 des oberen Richtungsschalters 51 ansprechen, insbesondere um zu gewährleisten, daß ein Umschalten der Richtungsschalter nur dann stattfindet, wenn sich der Probenträger an einer dieser Stellen befindet. Bei den Sensoren 87 bis 89 kann es sich in einfacher Weise um optische Sensoren handeln, die dann besonders leicht anzubringen sind, wenn die Rohre der Vorrichtung aus einem durchsichtigen Material, insbesondere einem durchsichtigen Kunststoff, bestehen. Die Verwendung eines durchsichtigen Kunststoffes für die Rohre der Vorrichtung hat in jedem Fall den Vorteil, daß die Stellung der Probe und die Funktion der Vorrichtung jederzeit visuell überwacht werden können. Dabei versteht es sich, daß auch die Teile der Richtungsschalter aus einem durchsichtigen Kunststoff bestehen können.

Es versteht sich, daß die Erfindung nicht auf die dargestellten Ausführungsbeispiele beschränkt ist, sondern Abweichungen davon möglich sind, ohne den Rahmen der Erfindung zu verlassen. Wesentlich für die Erfindung ist, daß durch Anwendung von Richtungsschaltern und Rohren, deren Richtung von der Richtung des den Kryomagneten durchsetzenden Führungsrohres abweicht, der Probenträger an eine Stelle gebracht werden kann, an welcher der Probenträger in das Ende des dort endenden Rohres eingesetzt oder aus diesem Ende leicht entnommen werden kann. Dabei können auch in gewissen Grenzen flexible und/oder gekrümmte Rohre Anwendung finden. Allerdings sollte im Hinblick auf die Anordnung der Probe möglichst vermieden werden, daß der Probenträger mit der Probe auf den Kopf gestellt wird. Für die Luftführung und die Stellung der Richtungsschalter ist selbstverständlich, daß die einzelnen Rohrabschnitte nacheinander in der Richtung zum bzw. von dem Meßbereich unter entsprechender Verstellung der Richtungsschalter durchlaufen werden müssen. Es versteht sich auch, daß die Richtungsschalter einen anderen Aufbau haben und/oder mit anderen Betätigungseinrichtungen, beispielsweise unter Verwendung von Bowdenzügen, versehen sein können als bei den dargestellten Ausführungsbeispielen, auch wenn sich diese Umschalter durch ihren besonders einfachen und platzsparenden Aufbau auszeichnen.

**Patentansprüche**

1. Vorrichtung zum Zuführen eines Probenträgers (4, 44) bei einem NMR-Spektrometer, das einen Hochfeld-Kryomagneten (2, 41) mit vertikal angeordneter Achse aufweist, der in einem vorgegebenen Meßbereich ein homogenes statisches Magnetfeld erzeugt, mit einem diesen Meßbereich durchsetzenden, vertikalen Führungsrohr (3, 43), mit einer am oberen Ende des Führungsrohres (3, 43) angeordneten Wechseleinrichtung zum Übergeben und Entnehmen eines Probenträgers (4, 44) an das bzw. aus dem Führungsrohr (3, 43) und mit einer Einrichtung zum Zuführen von unter Druck stehendem Gas zum unteren Ende des Führungsrohres (3, 43), mit der das dem Führungsrohr (3, 43) zugeführte Gas so dosierbar ist, daß ein an das Führungsrohr (3, 43) übergebener Probenträger (4, 44) wahlweise zum Durchführen einer Messung von dem oberen Ende des Führungsrohres (3, 43) bis in den Meßbereich des Kryomagneten (2, 41) abgesenkt und danach zum Entnehmen des Probenträgers (4, 44) wieder bis zum oberen Ende des Führungsrohres (3, 43) angehoben werden kann,
dadurch gekennzeichnet,
daß die Wechseleinrichtung ein Schrägrohr (15, 55), das von einer dem oberen Ende des Führungsrohres (3, 43) benachbarten Stelle zu einer außerhalb der Magnetanordnung liegenden, gut zugänglichen Stelle führt und dort mit einer verschließbaren Öffnung zum Einsetzen und Entnehmen des Probenträgers versehen ist, und einen Richtungsschalter (11, 51) umfaßt, der ein wahlweise auf das Führungsrohr und auf das Schrägrohr (15, 55) ausrichtbares Rohrstück (14, 54) aufweist, und daß die Einrichtung (6, 46) zum Zuführen des unter Druck stehenden Gases auch mit dem verschlossenen unteren Ende des Schrägrohres (15, 55) verbunden und derart steuerbar ist, daß der im Führungsrohr (3, 43) bei auf das Führungsrohr ausgerichtetem Rohrstück (14, 54) des Richtungsschalters (11, 51) bis in den Bereich des Richtungsschalters angehobene Probenträger (4, 44) nach Verstellen des Richtungsschalters im Schrägrohr (15, 55) zum Zwecke der Entnahme absenkbar ist und umgekehrt.

2. Vorrichtung nach Anspruch 1, dadurch gekennzeichnet, daß am unteren Ende des Schrägrohres (15) ein vom Schrägrohr trennbares, einseitig geschlossenes Endstück (17) mit einem Aufnahmeraum für den Probenträger (4) angeordnet ist.

3. Vorrichtung nach Anspruch 2, dadurch gekennzeichnet, daß ein beweglicher Abschnitt (13, 53) des Richtungsschalters (11), wenn dessen Rohrstück (14, 54) auf das Führungsrohr (3) oder das Schrägrohr (15) ausgerichtet ist, das Schrägrohr (15) bzw. das Führungsrohr (3) dicht abschließt und das Führungsrohr (3) mit dem geschlossenen Ende des Endstückes (17) durch eine flexible Leitung (19) verbunden ist, die an das Führungsrohr (13) in einem Abstand von dessen oberem Ende angeschlossen ist, der wenigstens so groß ist wie die Länge des Probenträgers (4).

4. Vorrichtung nach einem der vorhergehenden Ansprüche, dadurch gekennzeichnet, daß der Richtungsschalter (11) mittels eines Hebelgetriebes (21, 22) manuell verstellbar ist, das zusammen mit dem Richtungsschalter (11) ein System bildet, dessen gemeinsamer Schwerpunkt in den Betriebsstellungen, in denen der Richtungsschalter auf das Führungsrohr (3) oder das Schrägrohr (15) ausgerichtet ist, tiefer liegt als in den dazwischen liegenden Stellungen.

5. Vorrichtung nach einem der Ansprüche 2 bis 4, dadurch gekennzeichnet, daß das Endstück (17) am unteren Ende des Schrägrohres (15) lösbar befestigt ist.

6. Vorrichtung nach einem der Ansprüche 2 bis 4, dadurch gekennzeichnet, daß das Endstück (64) das Rohrstück eines weiteren Richtungsschalters (61) ist, von dem ein im wesentlichen senkrecht angeordnetes, oben offenes Aufnahmerohr (65) für den Probenträger ausgeht.

7. Vorrichtung nach Anspruch 6, dadurch gekennzeichnet, daß der weitere Richtungsschalter mit dem am oberen Ende des Führungsrohres angeordneten Richtungschalters mechanisch gekoppelt ist.

8. Vorrichtung nach einem der vorhergehenden Ansprüche, dadurch gekennzeichnet, daß der oder die Richtungsschalter (51, 61) und die Einrichtung (46) zum zuführen von Gas in Abhängigkeit von im Bereich der Richtungsschalter (51, 61) angeordneten Sensoren (87, 88, 89) mittels eines Steuergerätes (67) automatisch verstellt bzw. gesteuert werden.

## Claims

1.  Apparatus for supplying a sample carrier (4, 44) in the case of an NMR spectrometer comprising an intense field cryomagnet (2, 41) which has a vertically disposed axis and generates a homogeneous static magnetic field in a predetermined measuring area, having a vertical guide tube (3, 43) which penetrates this measuring area, with an exchange device which is disposed at the upper end of the guide tube (3, 43) for transferring and removing a sample carrier (4, 44) to or from the guide tube (3, 43) respectively, and with a device for delivering pressurised gas to the lower end of the guide tube (3, 43) by means of which device the gas delivered to the guide tube (3, 43) can be metered in such a way that a sample carrier (4, 44) transferred to the guide tube (3, 43) can be optionally lowered from the upper end of the guide tube (3, 43) to the measuring area of the cryomagnet (2, 41) for performing a measurement and can subsequently be raised again for removal of the sample carrier (4, 44) to the upper end of the guide tube (3, 43), characterised in that the exchange device comprises an inclined tube (15, 55), which leads from a point adjacent the upper end of the guide tube (3, 43) to an easily accessible point lying outside the magnet arrangement and is there provided with a closable opening for inserting and removing the sample carrier, and a direction switching device (11, 51) which comprises a tube part (14, 54) which can optionally be aligned on the guide tube and on the inclined tube (15, 55); and in that the device (6, 46) for supplying the pressurised gas is also connected to the closed lower end of the inclined tube (15, 55) and can be controlled in such a way that the sample carrier (4, 44), in the guide tube (3, 43), which is raised to the area of the direction switching device when the tube part (14, 54) of the direction switching device (11, 51) is aligned on the guide tube, can be lowered when the direction switching device has been adjusted in the inclined tube (15, 55) for the purposes of removal and vice versa.

2.  Apparatus according to Claim 1, characterised in that an end piece (17), which has an accommodating chamber for the sample carrier (4), can be separated from the inclined tube and is closed on one side, is disposed at the lower end of the inclined tube (15).

3.  Apparatus according to Claim 2, characterised in that when the tube part (14, 54) of the direction switching device (11) is aligned on the guide tube (3) or the inclined tube (15), a movable section (13, 53) of the direction switching device closes the inclined tube (15) or the guide tube (3) in a leaktight manner, and the guide tube (3) is connected to the closed end of the end piece (17) by a flexible pipe (19) which is connected to the guide tube (3) at a distance from the upper end thereof which is at least as great as the length of the sample carrier (4).

4.  Apparatus according to any one of the preceding claims, characterised in that the direction switching device (11) can be manually adjusted by means of a lever gear unit (21, 22) which together with the direction switching device (11) forms a system of which the common centre of gravity in the operating positions in which the direction switching device is aligned on the guide tube (3) or the inclined tube (15) is lower than in the positions lying therebetween.

5.  Apparatus according to any one of Claims 2 to 4, characterised in that the end piece (17) is detachably secured to the lower end of the inclined tube (15).

6.  Apparatus according to any one of Claims 2 to 4, characterised in that the end piece (64) is the tube part of a further direction switching device (61) from which there emerges a receiving tube (65) for the sample carrier, which tube is substantially vertical and is open at the top.

7.  Apparatus according to Claim 6, characterised in that the further direction switching device is mechanically coupled with the direction switching device disposed at the upper end of the guide tube.

8.  Apparatus according to any one of the preceding claims, characterised in that the direction switching device or devices (51, 61) and the device (46) for supplying gas can be automatically adjusted or controlled in dependence upon sensors (87, 88, 89) disposed in the vicinity of the direction switching devices (51, 61) by means of a control apparatus (67).

## Revendications

1.  Dispositif d'amenée d'un porte échantillon (4, 44) sur un spectromètre à résonance magnétique nucléaire (2, 41) à axe disposé verticalement, lequel génère, à l'intérieur d'une plage de mesures prédéterminées, un champ magnétique statique homogène, ce dispositif comportant un tube conducteur (3, 43) vertical traversant la dite plage de mesures, un dispositif changeur disposé sur l'extrémité supérieure du tube conducteur (3, 43) et destiné à remettre un porte échantillon (4, 44) au dit tube conducteur (3, 43) ou à le lui reprendre, ainsi qu'un dispositif pour amener un gaz sous pression vers l'extrémité inférieure du tube conducteur (3, 43) et permettant le dosage du gaz amené vers le dit tube (3, 43) de telle sorte qu'un porte échantillon (4, 44) remis au tube (3, 43) puisse, si l'on souhaite effectuer une mesure, être abaissé à partir de l'extrémité supérieure du tube (3, 43) jusqu'à pénétrer dans la plage de mesures et ensuite, être soulevé pour revenir jusqu'à l'extrémité supérieure du tube (3, 43) **caractérisé :**

- par le fait que le dispositif changeur comprend un tube oblique (15, 55) qui conduit d'un point proche de l'extrémité supérieure du tube conducteur (3, 43) vers un point facilement accessible situé à l'extérieur du dispositif magnétique et est muni en cet emplacement d'un orifice pouvant être obturé pour l'insertion et la désinsertion d'un porte échantillon, le dit dispositif changeur comprenant également un commutateur directionnel (11, 51) qui présente un élément tubulaire (14, 54) orientable, si on le désire, sur l'élément tubulaire (14, 54) et sur le tube oblique (15, 55) et

- en ce que le dispositif (6, 46) pour la conduction du gaz sous pression est également relié à l'extrémité inférieure fermée du tube oblique (15, 55) et qu'il est réglable de telle sorte que le porte échantillon (4, 44) qui, lorsque l'élément tubulaire (14, 54) du commutateur directionnel (11, 51) est aligné sur le tube conducteur (3, 43), est soulevé dans le tube conducteur (3, 43) jusqu'au voisinage du commutateur directionnel (11, 51), puisse, après réglage du dit commutateur directionnel, être abaissé dans le tube oblique (15, 55) afin de pouvoir procéder à la désinsertion et inversement.

2. Dispositif selon la revendication 1 **caractérisé** par le fait que, sur l'extrémité inférieure du tube oblique (15), est disposé un embout (17) fermé d'un côté et détachable du tube oblique comportant un espace de réception pour le porte échantillon (4).

3. Dispositif selon la revendication 2 **caractérisé** par le fait que la section mobile (13, 53) du commutateur directionnel (11), lorsque son élément tubulaire (14, 54) est orienté vers le tube conducteur (3) ou vers le tube oblique (15), ferme de manière étanche le dit tube oblique (15) ou le dit tube conducteur (3) et que le tube conducteur (3) est relié à l'extrémité fermée de l'embout (17) par une conduite flexible (19), laquelle est raccordée au tube conducteur (13) à une certaine distance de son extrémité supérieure, cette distance étant au moins égale à la longueur du porte échantillon (4).

4. Dispositif selon l une quelconque des revendications précédentes **caractérisé** par le fait que le commutateur directionnel (11) est réglable manuellement au moyen d'un mécanisme à levier (21, 22), lequel, associé au commutateur directionnel (11), constitue un système dont le centre de gravité commun, dans les positions de service dans lesquelles le dit conmutateur directionnel est orienté sur le tube conducteur (3) ou sur le tube oblique (15), est situé plus bas que dans les positions intermédiaires.

5. Dispositif selon l'une des revendications 2 à 4 **caractérisé** par le fait que l'embout (17) est fixé de manière amovible sur l'extrémité inférieure du tube oblique (15).

6. Dispositif selon l'une des revendications 2 à 4 **caractérisé** par le fait que l'embout (64) est l'élément tubulaire d'un autre commutateur directionnel (61) dont part un tube de réception (65) ouvert en haut, disposé sensiblement verticalement, qui est destiné au porte échantillon.

7. Dispositif selon la revendication 6 **caractérisé** par le fait que l'autre commutateur directionnel est accouplé mécaniquement au commutateur directionnel disposé sur l'extrémité supérieure du tube conducteur.

8. Dispositif selon l'une des revendications précédentes **caractérisé** par le fait que le ou les commutateurs directionnels (51, 61) et le dispositif (46) pour la conduction du gaz sont régulés automatiquement par des cellules sensibles (87, 88, 89) disposées au voisinage des dits commutateurs directionnels (51, 61) au moyen d'un instrument de régulation (67).

EP 0 308 654 B1

Fig.1

Preßluft

Fig. 2